Europäisches Patentamt

European Patent Office

Office européen des brevets

(11) Numéro de publication: **0 275 752 B1**

## FASCICULE DE BREVET EUROPEEN

(45) Date de publication de fascicule du brevet: **11.03.92**

(51) Int. Cl.5: **G06F 11/20**, G11C 17/00, G11C 5/00

(21) Numéro de dépôt: **87402859.0**

(22) Date de dépôt: **15.12.87**

(54) **Circuit intégré comportant des éléments d'aiguillage vers des éléments de redondance dans une mémoire.**

(30) Priorité: **19.12.86 FR 8617888**

(43) Date de publication de la demande:
**27.07.88 Bulletin 88/30**

(45) Mention de la délivrance du brevet:
**11.03.92 Bulletin 92/11**

(84) Etats contractants désignés:
**DE ES FR GB IT NL**

(56) Documents cités:
**EP-A- 0 098 215
EP-A- 0 148 510
EP-A- 0 159 928**

**HEWLETT-PACKARD JOURNAL, vol. 34, no. 8, août 1983, pages 20-24, Amstelveen, NL; J.K. WHEELER et al.: "128K-Bit NMOS dynamic RAM with redundancy"**

(73) Titulaire: **SGS-THOMSON MICROELECTRO-NICS S.A.
101 Boulevard Murat
F-75016 Paris(FR)**

(72) Inventeur: **Devin, Jean
THOMSON-CSF SCPI 19, avenue de Messine
F-75008 Paris(FR)**
Inventeur: **Calzi, Philippe
THOMSON-CSF SCPI 19, avenue de Messine
F-75008 Paris(FR)**

(74) Mandataire: **Ballot, Paul Denis Jacques
Cabinet Ballot-Schmit 7, rue le Sueur
F-75116 Paris(FR)**

EP 0 275 752 B1

Rank Xerox (UK) Business Services

## Description

La présente invention concerne les circuits intégrés qui comportent au moins une mémoire comprenant des éléments de redondance. Elle concerne plus particulièrement des éléments d'aiguillage vers les éléments de redondance de la mémoire.

Les éléments de redondance sont des éléments qui sont substitués aux éléments de la mémoire qui sont défectueux. La substitution doit être transparente pour l'utilisateur de la mémoire. Lorsqu'un utilisateur adresse une cellule mémoire et que cette cellule s'est révélée défectueuse lors des tests, un circuit a mémorisé cette anomalie de manière à provoquer un aiguillage vers l'élément de redondance désiré qui se substitue par conséquent à la cellule défectueuse sans que l'utilisateur en soit informé. Or, pour effectuer un tel aiguillage, il faut que des cellules mémoires soient consacrées à la mémorisation d'une information d'aiguillage vers une cellule de redondance déterminée, pour chaque cellule défectueuse.

Cette mémorisation s'effectue lors du premier test de la mémoire lorsque le circuit intégré se trouve sur plaquette, c'est-à-dire avant encapsulation. La mémorisation se fait par claquage ou non de fusibles prévus à cet effet. La connaissance de l'état de ces fusibles, par mesure de la tension entre une borne et un potentiel de référence permet d'adresser l'élément de redondance désiré.

Dans les circuits de type MOS, des résistances de faible valeur qui se présentent sous forme d'une couche polycristalline de silicium sont prévues et sont claquées à cet effet par une forte décharge éléctrique (ou par laser) lors du test de la mémoire. La couche polycristalline de silicium disparait et la résistance présente une impédance infinie. Un circuit de détection est prévu pour chaque fusible afin de connaître son état. L'inconvénient de cette méthode réside dans le fait qu'il faut un circuit de détection pour chaque fusible.

Par ailleurs pour claquer un fusible on a besoin d'une haute tension qui n'est pas utilisée de manière générale dans une mémoire puisque les tensions requises pour la lecture par exemple, sont de 0 à 5 V.

La seule haute tension disponible actuellement est la tension de programmation Vpp qui est choisie par le client. Les tensions de programmation requises se situent autour de 10 à 15 V. Or, avec l'évolution des technologies la tension de programmation requise diminue. Si bien qu'il sera impossible lorsque la technologie aura suffisamment évolué d'utiliser la tension de programmation des mémoires pour claquer les fusibles réservés au circuit d'aiguillage.

Dans l'état actuel, il est usuel d'utiliser cette tension de programmation Vpp pour claquer ces fusibles. Pour cela, la tension est appliquée à partir d'un plot commun qui sert à la programmation de la mémoire et également lors des tests, au claquage des fusibles. Les fusibles sont connectés directement entre le potentiel Vpp et la masse à travers un transistor de commande. Les fusibles sont claqués lorsque les transistors sont conducteurs.

Cette solution n'est pas sans risque. En effet, comme la tension d'alimentation est commune au claquage des fusibles et à la programmation, les fusibles qui n'ont pas été claqués, risquent de recevoir une différence de potentiel, car les transistors de commande même s'ils ne sont pas commandés conduisent par un phénomène de perçage qui se produit en présence d'une haute tension.

Les caractéristiques des fusibles se dégradent donc au cours de la programmation des mémoires. Ce vieillissement conduit à la longue à un changement d'état involontaire des fusibles.

La présente invention propose de remédier à ces inconvénients et propose de prévoir dans le circuit intégré à mémoire, un plot supplémentaire relié à tous les fusibles mais qui ne sera pas relié au brochage externe du circuit intégré, ce plot étant relié à un circuit qui est générateur de basse tension lors de la programmation de la mémoire et qui est apte à présenter une haute impédance lorsqu'une haute tension est appliquée sur le plot pour que tout le courant passe dans les fusibles que l'on veut claquer.

La présente invention a donc pour objet un circuit intégré comportant au moins une mémoire qui comprend au moins un élément de redondance et au moins un fusible pour provoquer un aiguillage vers un élément de redondance ; principalement caractérisé en ce qu'il comporte :

- un circuit transformateur d'impédance (2) comprenant une entrée et une sortie, l'entrée recevant un signal de commande de mode de fonctionnement ;
- un plot supplémentaire non relié au brochage externe du circuit intégré, destiné à recevoir une alimentation haute tension (V) vis-à-vis de la tension d'alimentation (Vcc), la sortie du circuit transformateur d'impédance étant reliée à ce plot (P) et à une borne (N) d'au moins un fusible (R) ; le circuit transformateur d'impédance présentant une haute impédance vis-à-vis du ou des fusibles lorsque le signal de commande de mode de fonctionnement présente un premier état logique, cet état logique étant présent lorsque ladite haute tension (V) est appliquée sur le plot (P) ; ce circuit transformateur d'impédance présentant une faible impédance et étant apte à alimenter le ou les fusibles sous une tension plus faible (Vcc) lorsque le plot n'est plus alimenté, le signal de commande de mode de fonctionnement, présentant alors un deuxième état logique.

D'autres particularités et avantages de l'invention apparaitront mieux à la lecture de la description détaillée qui suit et se réfère aux dessins annexés, donnés uniquement à titre d'exemple non limitatif et dans lesquels :

- la figure 1, représente le schéma général de l'invention selon le mode de claquage des fusibles ;
- la figure 2, représente le schéma général de l'invention selon le mode de lecture ;
- la figure 3, représente un exemple de réalisation particulier de l'invention.

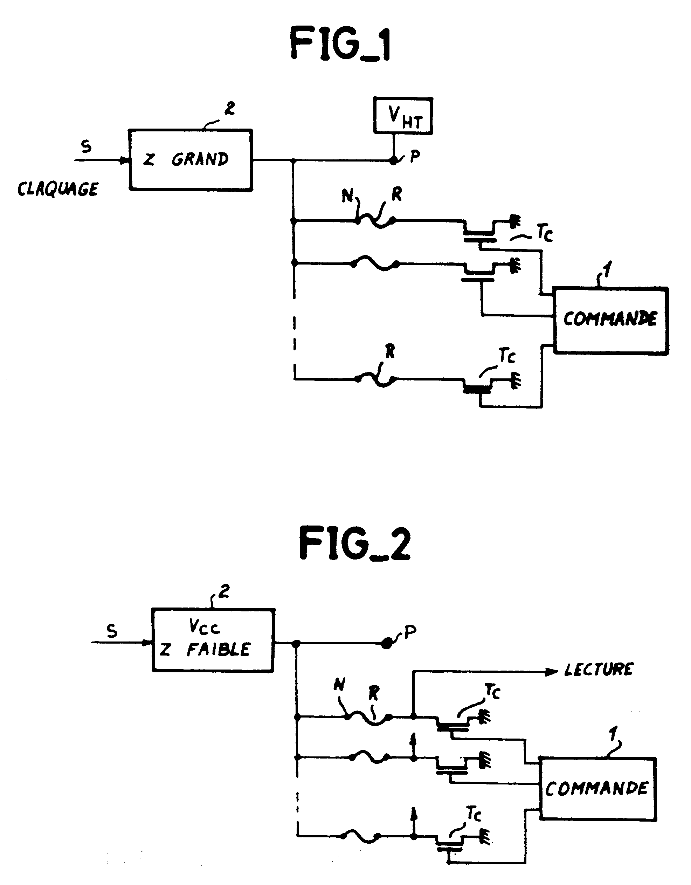

Sur la figure 1, on a représenté le schéma général du circuit de claquage selon l'invention lors du claquage des fusibles qui a lieu pendant les tests du circuit intégré.

Sur la figure 2, on a représenté le schéma général de ce circuit lors du fonctionnement du circuit intégré, on effectue la programmation d'éléments mémoires qui sont réservés à la mémorisation d'aiguillage vers un élément mémoire de redondance déterminé. Ces éléments mémoires sont constitués chacun par un fusible R relié à un transistor de commande Tc. Chaque transistor Tc est relié à un circuit 1 apte à commander la conduction du transistor Tc désiré. La grille de ces transistors Tc est reliée au circuit 1, l'une des deux autres électrodes principales est reliée à la masse, l'autre est reliée à une borne d'un fusible R. La deuxième borne N de chaque fusible R est reliée d'une part à un plot P et d'autre part à un circuit transformateur 2 qui reçoit un ordre S traduisant le mode de fonctionnement du circuit intégré. Ce mode de fonctionnement est soit le mode claquage, soit le mode normal de lecture de l'état des fusibles à chaque adressage de la mémoire.

Le plot P est un plot supplémentaire prévu pour le test du circuit intégré mais qui n'est pas destiné à être relié aux broches externes de ce circuit.

Ce plot P est destiné à recevoir une haute tension V lors des tests qui est directement appliquée aux fusibles, cette tension étant suffisante pour claquer les fusibles R, V = 15 à 20 V par exemple.

Le circuit 2 permet, en fonction de l'état logique du signal de commande de présenter une haute impédance vue du plot. Ainis aucun courant utile pour le claquage n'est dérivé vers ce circuit lors de l'application de la haute tension V. Les fusibles reliés à des transistors Tc conducteurs sont claqués.

Après avoir claqué les fusibles qu'il convenait de claquer, la haute tension V est retirée , le plot est flottant. L'état logique du signal de commande est modifié de sorte que le circuit se comporte en générateur de basse tension Vcc, faible impédance vue du circuit de fusibles. La basse tension Vcc est suffisante (par exemple 5 V) pour permettre la lecture de l'état de chaque fusible, cette lecture étant faite de manière classique en soi.

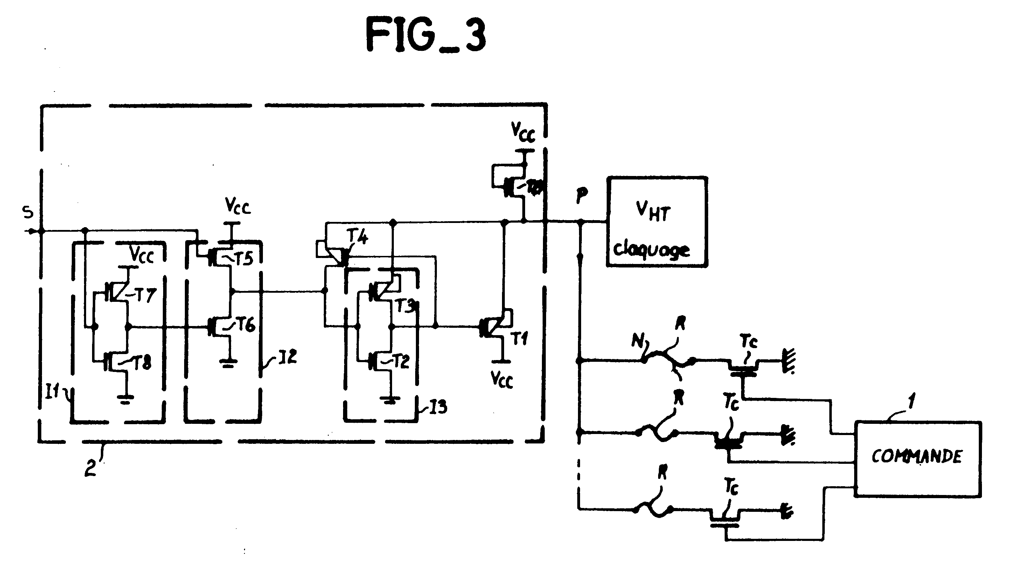

Sur la figure 3, on a représenté un mode de réalisation particulier de l'invention.

On prendra à titre d'example comme niveau haut de tension d'alimentation des transistors MOS du circuit, la tension Vcc à 5 V et comme niveau bas 0 V.

Le circuit 2 comporte tout d'abord trois inverseurs en série I1, I2, I3. Le premier inverseur I1 comprend un transistor MOS à canal P, T7, dont la source est reliée à la tension Vcc et dont le drain est relié au drain d'un transistor MOS à canal N, T8. La source du transistor T8 est reliée à la masse (0 V), la grille des deux transistors reçoit le signal de commande S dont le niveau de tension est soit Vcc, soit la masse selon le mode de fonctionnement désiré. Le deuxième inverseur 12 comporte deux transistors MOS à canal N, T5 et T6. Les drains de ces transistors sont reliés, la source du transistor T6 est à la masse, la source du transistor T5 est au potentiel Vcc. La grille du transistor T5 est commandée par le signal S. La grille du transistor T6 est commandée par la sortie de l'inverseur I1.

La sortie de l'inverseur I2 est prise au point connu des deux drains, cette sortie commande la grille de deux autres transistors T3 et T2 montés de manière à former le troisième inverseur I3. Le transistor T3 est un transistor MOS à canal P, le transistor T2 est un transistor MOS à canal N. La source du transistor T2 est reliée à la masse, la source du transistor T3 est au potentiel V, 20 Volts lorsque la tension V est appliquée, soit au potentiel Vcc dans le cas contraire.

La sortie de cet inverseur commande la grille d'un transistor MOS à canal, P, T4, qui a sa source reliée au potentiel V (20 V) ou Vcc (5 V) selon que la tension V est appliquée ou non sur le plot. Le drain de ce transistor est relié à la sortie de l'inverseur I2. Un transistor MOS canal P est commandé par la sortie de l'inverseur I3, son drain est au potentiel Vcc et sa source est au potentiel V ou Vcc.

Un transistor MOS à canal N, TO est commandé par la tension Vcc appliquée sur sa source. Le drain de ce transistor se trouve au potentiel V ou Vcc.

Le circuit 2 fonctionne de la manière suivant :

Pour effectuer le claquage des fusibles le signal S est à 0 V et la tension 20 V est appliquée sur le plot P. Le transistor T8 est bloqué, le transistor T7 est conducteur. Le transistor T6 est conducteur, le transistor T5 est bloqué. Le transistor T2 est bloqué et le transistor T3 est conducteur. Le transistor T3 amène la tension V (20 V) sur la grille du transistor T1 ce qui le bloque. Le transistor T3 amène cette tension de 20 V sur la grille du transistor T4 qui se bloque également. Il n'y a plus alors de chemin de courant pour dévier le courant des fusibles.

Pour le fonctionnement normal en lecture, le signal S est au potentiel Vcc soit 5 V, et le plot est flottant (aucune tension n'est appliquée.

Le transistor T8 est conducteur et T7 est bloqué. Le transistor T6 est bloqué et T5 est conducteur. Le transistor T2 est conducteur et T3 est bloqué. Le transistor T4 tend alors à devenir conducteur et à créer un chemin de courant T0, T4, T2 avec trois transistors conducteurs en série. Un potentiel Vcc - Vg tend à s'établir sur le plot. Mais le transistor T1 a 0 V sur sa grille et est donc conducteur, son drain est connecté à Vcc et sa source ramène alors Vcc sur le plot, le transistor T0 ne servant alors plus à rien. Ce transistor T0 permet en fait d'amorcer une polarisation convenable des transistors T4 et T3 après quoi T4 et T3 sont bien alimentés par la tension Vcc et le plot est au potentiel sans provoquer de vieillissement prématuré.

Cet exemple particulier de réalisation présente l'avantage d'obtenir un lien direct entre la tension de claquage V et les fusibles, le positionnement de cette tension se faisant sans passer par une résistance série.

Le circuit d'aiguillage selon l'invention permet donc contrairement à l'art antérieur, de dissocier les opérations de programmation d'une mémoire et celles du claquage des fusibles.

## Revendications

1. Circuit intégré comportant au moins une mémoire qui comprend au moins un élément de redondance et au moins un fusible pour provoquer un aiguillage vers un élément de redondance, caractérisé en ce qu'il comporte :
   - un circuit transformateur d'impédance (2) comprenant une entrée et une sortie, l'entrée recevant un signal de commande de mode de fonctionnement (S) ;
   - un plot (P) supplémentaire non relié au brochage externe du circuit intégré, destiné à recevoir une alimentation haute tension (V) vis-à-vis de la tension d'alimentation (Vcc), la sortie du circuit transformateur d'impédance étant relié à ce plot (P) et à une borne (N) d'au moins un fusible (R) ; le circuit transformateur d'impédance (2) présentant une haute impédance vis-à-vis du ou des fusibles (R) lorsque le signal de commande de mode de fonctionnement (S) présente un premier état logique, cet état logique étant présent lorsque ladite haute tension (V) est appliquée sur le plot (P) ; ce circuit transformateur d'impédance (2) présentant une faible impédance et étant apte à alimenter le ou les fusibles sous une tension (Vcc) plus faible lorsque le plot (P) n'est plus alimenté, le signal de commande de mode de fonctionnement (S) présentant alors un deuxième état logique.

2. Circuit intégré selon la revendication 1, caractérisé en ce que le circuit transformateur d'impédance (2) comporte un premier (I1), un deuxième (12), un troisième (13) inverseurs en série, le premier inverseur étant attaqué par le signal de commande de mode de fonctionnement (S), le troisième inverseur attaquant la grille d'un premier (T4) et d'un deuxième (T1) transistor MOS à canal P dont les drains qui constituent la sortie du circuit transformateur d'impédance (2) reçoivent soit ladite haute tension lorsque le signal de commande de fonctionnement (S) a un premier état déterminé ce qui les bloque (T1, T4) et qui empêche toute dérivation du courant de claquage des fusibles à travers le circuit transformateur d'impédance (2) ; soit une tension suffisante pour amorcer un chemin de courant qui rend lesdits deux transistors (T1, T4) conducteurs, le deuxième transistor (T1) ramenant ainsi la basse tension à son drain et à la sortie du circuit (2), lorsque le signal de commande de mode de fonctionnement (S) a ledit second état logique.

3. Circuit intégré, selon la revendication 2, caractérisé en ce que le premier (11) et le troisième (13) inverseur comprennent un transistor à canal N (T8), (T2) et un transistor à canal P (T7), (T3) et en ce que le deuxième inverseur (I2) comporte deux transistors (T5, T6) à canal N.

4. Circuit intégré, selon la revendication 3, caractérisé en ce que :
   - la grille des deux transistors (T7, T8) du premier inverseur (I1) est attaquée par le signal de commande de mode de fonctionnement (S) et en ce que leur drain commande la grille d'un transistor (T6) du deuxième inverseur (I2), la grille de l'autre transistor (T5) étant attaqué par le signal de commande de mode de fonctionnement (S) ;
   - le drain et la source des transistors (T5, T6) du deuxième inverseur (I2) attaquent la grille des transistors (T3, T2) du troisième inverseur (I3), les drains de ces deux transistors (T2, T3) attaquent la grille dudit deuxième transistor (T1) et la grille dudit premier transistor (T4) ;

- un troisième transistor MOS à canal N (T0) a son drain relié à la source du transistor à canal P (T3) du troisième inverseur et aux drains desdits premier et deuxième transistors (T1, T4), ce transistor (T0) permettant d'amorcer une polarisation du premier transistor (T4) et du transistor MOS à canal P (T3) du troisième inverseur (13).

**Claims**

1. An integrated circuit comprising at least one memory which comprises a redundant element and at least one fuse in order to cause a diversion to a redundant element, characterized in that it comprises:
   - a impedance transforming circuit (2) comprising an input and an output, said input receiving a control signal (S) for the mode of functioning;
   - a supplementary contact (P) not connected with the external pinning of the integrated circuit adapted to receive a high voltage supply (V) in relation to the feed voltage (Vcc), the output of the impedance transforming circuit being connected with this contact (P) and with a terminal (N) of at least one fuse (R); the impedance transforming circuit (2) having a high impedance in relation to the fuse or fuses (R) when the control signal (S) for the mode of functioning has a first logical state, this logical state being present when the said high voltage (V) is applied to the contact (P); the said circuit having a low impedance and being adapted to feed the fuse or fuses at a lower voltage (Vcc) when the contact (P) is not supplied, the control signal (S) for the mode of functioning then being in a second logical state.

2. The integrated circuit as claimed in claim 1, characterized in that the impedance transforming circuit (2) comprises a first (I1), a second (I2), and a third (I3) inverter in series, the first inverter being acted upon by a control signal (S) for the mode of function, the third inverter acting upon the gate of a first (T4) and a second (T1) MOS transistor with a P channel whose drains, which constitute the output of the impedance transforming circuit (2), receive either the high voltage when the function control signal (S) has a first predetermined condition, thus blocking the same (TA and T4) and which prevents any escape of fuse breakdown current through the function control circuit, or a sufficient voltage to initiate a current path which renders the said two transistors (T1 and T4) conducting, the second transistor (T1) thus passing the low voltage to its drain at the output of the circuit (2), when the function mode control signal (2) has its second condition.

3. The integrated circuit as claimed in claim 2, characterized in that the first (I1) and the third (13) inverter comprise an N channel transistor (T8) and (T2) and a P channel transistor (T7) and (I3) and in that the second inverter (I2) comprises two N channel transistors (T5 and T6).

4. The integrated circuit as claimed in claim 3, characterized in that:
   - the gate of the two transistors (T7 and T8) of the first inverter (I1) is acted upon by the function mode control signal (S) and in that their drain controls the gate of a transistor (T6) of the second inverter (I2), the gate of the other transistor (T6) being acted upon by the function mode control signal (S);
   - the drain and the source of the transistors (T5 and T6) of the second inverter (I2) act upon the gate of the transistors (T3 and T2) of the third inverter (I3), the drains of these two transistors (T2 and T3) acting upon the gate of the said second transistor (T1) and the gate of the said first transistor (T4);
   - a third N channel MOS transistor (T0) has its drain connected with the source of the P channel transistor (T3) of the third inverter and with the drains of the said first and second transistors (T1 and T4), said transistor (T0) making it possible to initiate a polarization of the first transistor (T4) and of the P channel MOS transistor (T3) of the third inverter (I3).

**Patentansprüche**

1. Integrierte Schaltung mit wenigstens einem Speicher, der wenigstens ein Redundanzelement und wenigstens einen Schmelzeinsatz, der eine Verzweigung zu einem Redundanzelement bewirkt, aufweist, dadurch gekennzeichnet, daß sie umfaßt:
   - eine Impedanztransformator-Schaltung (2), die einen Eingang und einen Ausgang umfaßt, wobei der Eingang ein Betriebsart-Steuersignal empfängt;

- einen zusätzliche Anschlußpunkt (P), der nicht mit den externen Anschlüssen der integrierten Schaltung verbunden ist und dazu bestimmt ist, eine gegenüber der Versorgungsspannung (Vcc) hohe Versorgungsspannung (V) zu empfangen, wobei der Ausgang der Impedanztransformator- Schaltung mit diesem Anschlußpunkt (P) und einem Anschluß (N) wenigstens eines Schmelzeinsatzes (R) verbunden ist; wobei die Impedanztransformator-Schaltung (2) eine gegenüber den Schmelzeinsätzen (3) hohe Impedanz aufweist, wenn das Betriebsart-Steuersignal (S) einen ersten logischen Zustand besitzt, der dann vorliegt, wenn die Hochspannung (V) an den Anschlußpunkt (P) angelegt wird; wobei diese Impedanztransformator-Schaltung (2) eine geringe Impedanz aufweist und für die Versorgung des Schmelzeinsatzes oder der Schmelzeinsätze mit einer geringeren Spannung (Vcc) geeignet ist, wenn der Anschlußpunkt (P) nicht mehr versorgt wird, wobei dann das Betriebsart-Steuersignal (S) einen zweiten logischen Zustand besitzt.

2. Integrierte Schaltung gemäß Anspruch 1, dadurch gekennzeichnet, daß die Impedanztransformator-Schaltung (2) einen ersten (I1), einen zweiten (I2) und einen dritten (I3) Invertierer, die in Reihe geschaltet sind, aufweist, wobei in den ersten Invertierer das Betriebsart-Steuersignal (S) einwirkt, wobei der dritte Invertierer auf das Gate eines ersten (T4) und eines zweiten (T1) P-Kanal-MOS-Transistors einwirkt, deren Drains, die den Ausgang der Impedanztransformator-Schaltung (2) bilden, entweder die hohe Spannung empfangen, wenn das Betriebsart-Steuersignal (S) einen gegebenen ersten Zustand besitzt, der sie (T1, T4) sperrt und jeglichen Abfluß eines Durchbrennstroms für die Schmelzeinsätze durch die Impedanztransformator-Schaltung (2) blockiert; oder eine Spannung empfangen, die einen Strompfad erzeugt, der die zwei Transistoren (T1, T4) in den leitenden Zustand versetzt, wobei der zweite Transistor (T1) auf diese Weise die niedrige Spannung an seinem Drain und am Ausgang der Schaltung (2) verringert, wenn das Betriebsart-Steuersignal (S) den zweiten logischen Zustand besitzt.

3. Integrierte Schaltung gemäß Anspruch 2, dadurch gekennzeichnet, daß der erste (I1) und der dritte (I3) Invertierer einen N-Kanal-Transistor (T8), (T2) und einen P- Kanal-Transistor (T7), (T3) umfassen und daß der zweite Invertierer (I2) zwei N-Kanal-Transistoren (T5, T6) enthält.

4. Integrierte Schaltung gemäß Anspruch 3, dadurch gekennzeichnet, daß:
- auf das Gate der zwei Transistoren (T7, T8) des ersten Invertierers (I1) das Betriebsart-Steuersignal (S) einwirkt und ihr Drain das Gate eines Transistors (T6) des zweiten Invertierers (I2) steuert, wobei auf das Gate des anderen Transistors (T5) das Betiebsart-Steuersignal (S) einwirkt;
- der Drain und die Source der Transistoren (T5, T6) des zweiten Invertierers (I2) auf das Gate der Transistoren (T3, T2) des dritten Invertierers (I3) einwirken und die Drains dieser zwei Transistoren (T2, T3) auf das Gate des zweiten Transistors (T1) und das Gate des ersten Transistors (T4) einwirken;
- ein dritter N-Kanal-MOS-Transistor (T0) mit seinem mit der Source des P-Kanal-Transistors (T34) des dritten Invertierers verbundenen Drain mit den Drains des ersten und des zweiten Transistors (T1, T4) verbunden ist, wobei dieser Transistor (T0) die Ausbildung einer Polarisierung des ersten Transistors (T4) und des P-Kanals-MOS-Transistors (T3) des dritten Invertierers (I3) ermöglicht.

# FIG_1

# FIG_2

# FIG_3

EP 0 275 752 B1